# EUROPEAN PATENT APPLICATION

(11) **EP 2 051 376 A1**
(43) Date of publication of application: **22.04.2009**
(21) Application number: 08166796.6
(22) Date of filing: 16.10.2008
(51) Int. Cl.: H03H 9/10

(54) **Quartz crystal device**

(30) Priority: 18.10.2007 JP 2007271426
(71) Applicant: Nihon Dempa Kogyo Co., Ltd., Tokyo 151-8569 (JP)
(72) Inventor: Komada, Kenichi, Saitama 350-1321 (JP); Ariji, Takumi, Saitama 350-1321 (JP); Murakoshi, Hiroyuki, Saitama 350-1321 (JP)
(74) Representative: Cabinet Plasseraud

(57) **Abstract**

A quartz crystal device includes: a container; a crystal blank hermetically encapsulated in the container; and at least two outside terminals provided on an outer bottom surface of the container and used to surface-mount the quartz crystal device on a wiring board. Each outside terminal has a two-layer structure with a first layer provided on the outer bottom surface and a second layer provided on the first layer and having a flat surface. The second layer has a smaller plane shape than the first layer and is formed on a central part of the first layer at a distance from the perimeter of the first layer.

## Description

### Background of the Invention:

### 1. Field of the Invention:

The present invention relates to a quartz crystal device having a configuration with a quartz crystal blank hermetically encapsulated in a container, and more particularly, to a quartz crystal device for surface mounting, when surface-mounted on a wiring board, capable of preventing cracks in a solder layer used for mounting.

### 2. Description of the Related Arts:

Quartz crystal units having a quartz crystal blank hermetically accommodated in a container, and quartz crystal oscillators, in which such a crystal unit and an IC (integrated circuit) chip having a circuit using the crystal unit are integrated, are generically called "quartz crystal devices." The quartz crystal devices are used for a variety of electronic devices. For example, surface-mount crystal units having a crystal blank hermetically encapsulated in a container for surface mounting are small and light, and are therefore widely used in an oscillation circuit as frequency and time reference sources and incorporated in a variety of electronic devices. Surface-mount quartz crystal devices are surface-mounted on wiring boards of electronic devices using techniques such as reflow soldering.

In recent years, such surface-mount quartz crystal devices are also widely used for vehicle-mounted electronic devices exposed to large variations of temperature environment. Since large heat cycles are added to surface-mount quartz crystal devices used for vehicle-mounted electronic devices, there is a possibility that cracks may occur in solder when surface-mounted on wiring boards with solder as secular variations due to a difference in thermal expansion coefficient. Therefore, there is a demand for surface-mount quartz crystal devices capable of preventing such cracks in solder.

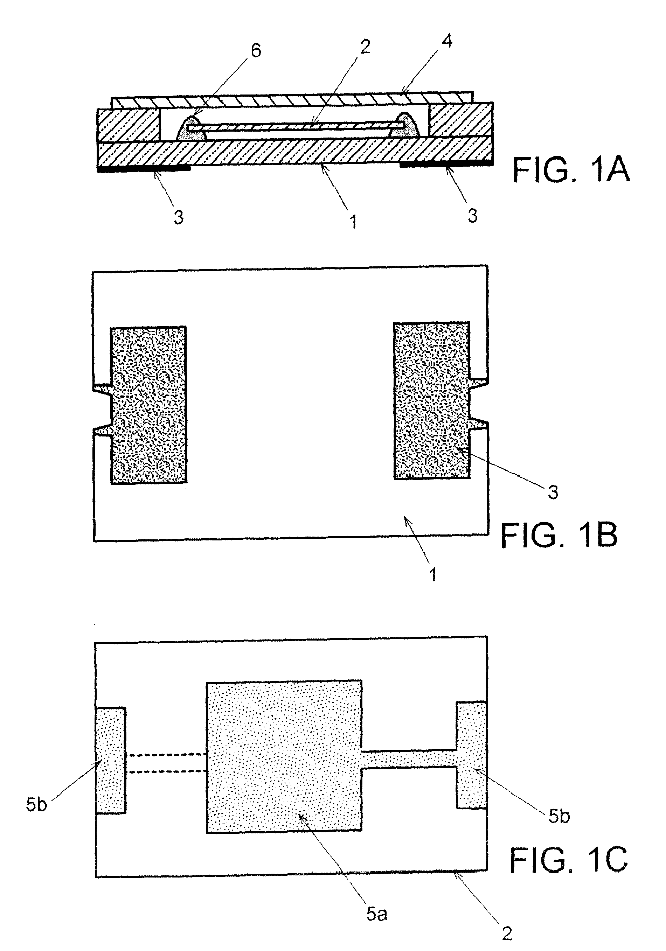

FIGS. 1A and 1B are a cross-sectional view and a bottom view, respectively, showing a configuration example of a surface-mount crystal unit, which is an example of a conventional surface-mount quartz crystal device, and FIG. 1C is a plan view of the crystal blank used for this crystal unit. The crystal unit shown here is of a two-terminal type with two outside terminals 3 used for surface mounting on a wiring board, and crystal blank 2 is accommodated in a flat and substantially rectangular parallelepiped container.

The container is made up of flat container body 1 made of laminated ceramics, in one principal surface of which a substantially rectangular recess is formed, and cover 4 that closes the opening of the recess. Two outside terminals 3 are provided at both ends of the outer bottom surface of container body 1 as electrode layers respectively. Holding terminals (not shown) are provided at both ends in the longitudinal direction of the inner bottom surface of the recess of container body 1. These holding terminals are electrically connected to outside terminals 3 via a conductive path (not shown) formed in the lamination plane between the ceramic sheet of the laminated ceramics and an end face electrode formed on the outer side surface of container body 1. When container body 1 is formed by stacking and burning ceramic green sheets (i.e., unburned raw ceramic sheets), the end face electrode is formed by conducting through-hole work and providing a conductive film on the through-hole worked surface.

As shown in FIG. 1C, crystal blank 2 is a substantially rectangular AT-cut quartz crystal blank and excitation electrodes 5a are formed on both principal surfaces thereof. Lead-out electrodes 5b extend from the pair of excitation electrodes 5a toward both ends of crystal blank 2. Each lead-out electrode 5b is formed so as to fold back between both principal surfaces of crystal blank 2 at the end positions of crystal blank 2. Crystal blank 2 is fixed and held in the recess, electrically and mechanically connected to container body 1 by fixing these lead-out electrodes 5b to the holding terminals at the positions where the pair of lead-out electrodes 5b are led out using, for example, conductive adhesive 6. Crystal blank is thus electrically connected to outside terminals 3. Crystal blank 2 is then hermetically sealed in container body 1 by bonding cover 4 made of ceramic or the like on the top surface of container body 1 at positions surrounding the opening of the recess through glass sealing to close the recess.

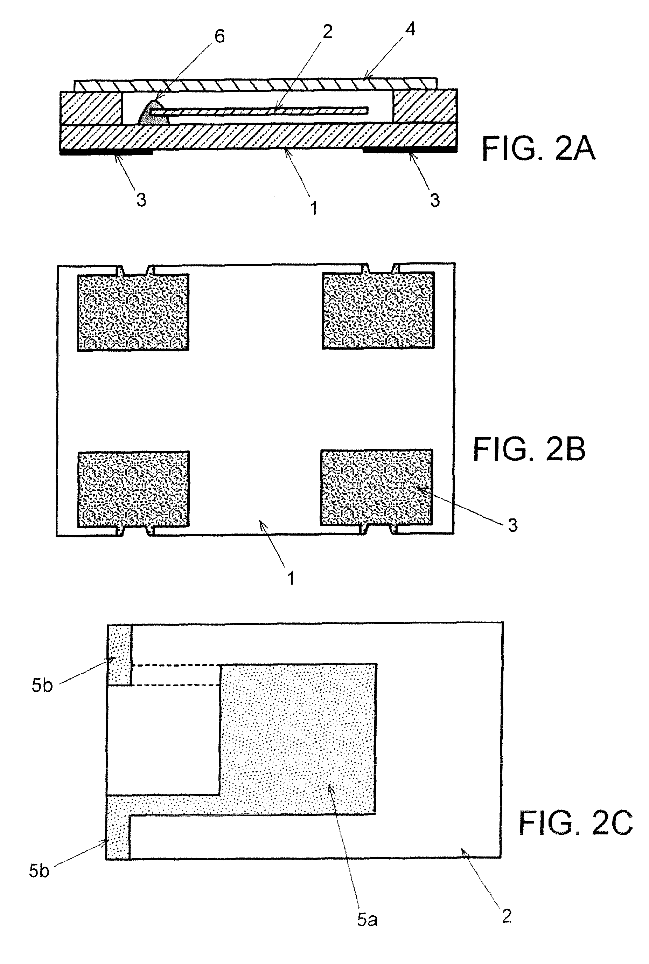

Furthermore, there is also a four-terminal type crystal unit provided with four outside terminals 3 whose cross-sectional view and bottom view are shown in FIGS. 2A and 2B, respectively. As in the case of the aforementioned two-terminal type, the four-terminal type crystal unit also uses container body 1 having a recess and made of laminated ceramics, and accommodates crystal blank 2 in the recess. Cover 4 closes the recess and crystal blank 2 is hermetically encapsulated in container body 1. Here, outside terminals 3 are provided in four corners of the outer bottom surface of container body 1.

The four-terminal type crystal unit is provided with a pair of holding terminals near both ends of one short side of the inner bottom surface of the recess of container body 1. The holding terminals are electrically connected to outside terminals 3 located at both ends of one diagonal of the outer bottom surface of container body 1 via the above described conductive path and side electrode. Outside terminals 3 located at both ends of the other diagonal are used as grounding terminals.

Crystal blank 2 used for the four-terminal type crystal unit is a substantially rectangular AT-cut quartz crystal blank as shown in FIG. 2C, excitation electrodes 5a are formed on both principal surfaces respectively and lead-out electrodes 5b extend from these excitation electrodes 5a toward both sides of one end in the longitudinal direction of crystal blank 2. Each lead-out electrode 5b is formed so as to fold back between both principal surfaces of the crystal blank 2 at the end position of crystal blank 2. As in the case of the two-terminal type, crystal blank 2 is held in the recess by fixing lead-out electrodes 5b to the holding terminals using, for example, conductive adhesive 6. By seam-welding metallic cover 4 to the top surface of container body 1 at positions surrounding the opening of the recess, the recess is closed by cover 4 and crystal blank 2 is hermetically sealed in container body 1. Cover 4 is electrically connected to outside terminals s for grounding via a conductive path formed in container body 1.

The above described two-terminal type or four-terminal type quartz crystal device for surface mounting is mounted and fixed to wiring board 7 of, for example, an electronic device boarded on a vehicle by means of reflow soldering. In reflow soldering, cream solder is applied to circuit terminals 9 formed on wiring board 7 as a circuit pattern by printing, and the quartz crystal device is placed on the cream solder. The quartz crystal device together with wiring board 7 is then put into a high temperature furnace, cream solder is melted, then cooled and the quartz crystal device is thereby surface-mounted on wiring board 7 by solder 8. General solder may also be used instead of cream solder and the composition of solder is not limited to a tin (Sn)-lead (Pb) alloy and may be lead-free solder. Wiring board 7 is made up of, for example, a glass-epoxy multilayer wiring board.

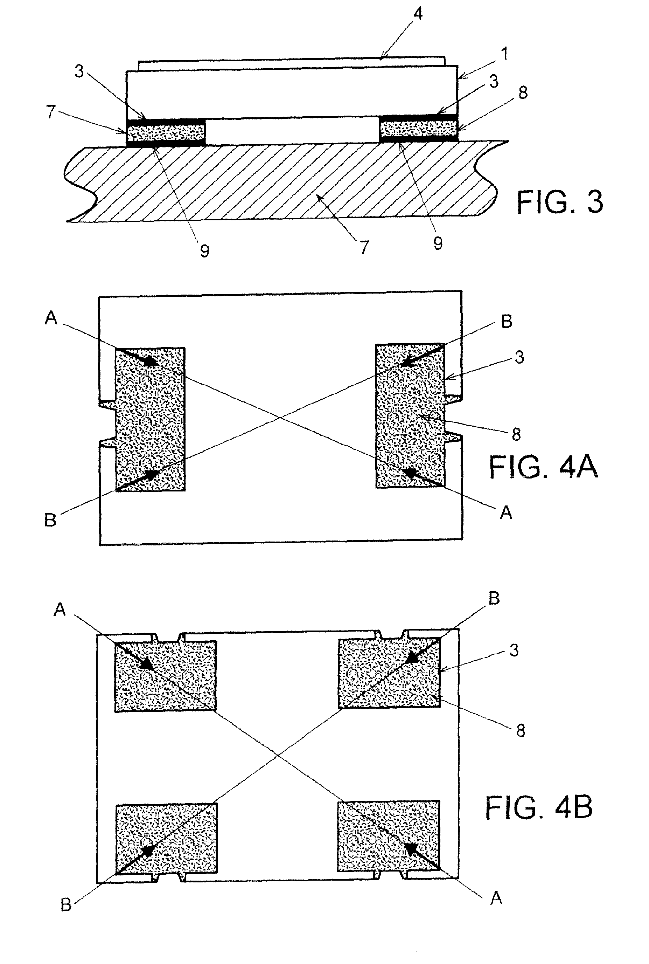

However, the above described conventional surface-mount quartz crystal device has a problem that when heat cycles are continuously added, cracks are produced in solder 8 due to a difference in thermal expansion coefficient between the ceramic making up container body 1 and the wiring board. For example, in the case of the above described two-terminal type quartz crystal device, as shown by the A-A line, B-B line and arrows in FIG. 4A, solder cracks may be produced from the perimeter in the diagonal direction of the pair of outside terminals 3 provided on the outer bottom surface of container body 1.

In the case of the four-terminal type crystal device, as shown by the A-A line, B-B line and arrows in FIG. 4B, solder cracks may be likewise produced on the outer bottom surface of container body 1 in outside terminals 3 provided in four corners along the diagonal line from the perimeter to the center. These cracks are attributable to the fact that stress based on a difference in thermal expansion coefficient is strongest in the diagonal direction of the outer bottom surface of container body 1. Such stress is concentrated on any one of outside terminals 3 and solder cracks are produced from the perimeter side of that outside terminal 3.

The occurrence of cracks in solder 8 in this way provokes peeling of outside terminals 3 from wiring board 7, dropping off of the quartz crystal device, poor connection between wiring board 7 and quartz crystal device or the like.

Japanese Patent Laid-Open Application No. 2001-308490 (JP-A-2001-308490) discloses a quartz crystal device for surface mounting provided with many micro projections and depressions in the surfaces of outside terminals to improve bonding strength between outside terminals and a wiring board.

Japanese Patent Laid-Open Application No. 2006-5027 (JP-A-2006-005027) discloses a surface-mount quartz crystal device having a container body, four corners of an outer bottom surface of which are formed into an arc shape and outside terminals of which are also formed into an arc shape to prevent the above described concentration of stress based on a difference in thermal expansion coefficient.

### Summary of the Invention:

It is an object of the present invention to provide a quartz crystal device for surface mounting capable of preventing cracks in solder when surface-mounted on a wiring board using the solder.

The present inventors have examined the mechanism whereby solder cracks are produced when a conventional surface-mount quartz crystal device is surface-mounted on a wiring board and brought the present invention to perfection. When soldering is performed, not only a solder alloy but also flux is used and the present inventors discovered through observations that solder cracks are caused by flux mixed into solder and the cracks expand. That is, when a crystal unit is mounted on a wiring board, flux expands and evaporates due to soldering heat, which causes micro bubbles to be produced in melted solder. The melted solder solidifies without being sufficiently deaerated, which results in micro voids remaining in the solidified solder layer.

When a quartz crystal device is surface-mounted on a wiring board, if voids in solder are distributed uniformly, strength of solder in corners on the perimeter side of outside terminals where stress due to a difference in thermal expansion coefficient is concentrated also decreases, which makes solder cracks due to heat cycles liable to occur. Small cracks occurring from the corners of the perimeter advance along voids distributed in solder and increase cracks themselves.

Therefore, the present inventors have discovered that it is possible to decrease voids remaining in solder caused by flux and thereby prevent the occurrence of cracks in solder and brought the present invention to perfection.

The object of the present invention can be achieved by a quartz crystal device including: a container; a crystal blank hermetically encapsulated in the container; and at least two outside terminals provided on an outer bottom surface of the container and used for surface mounting, wherein each outside terminal has a two-layer structure with a first layer provided on the outer bottom surface and a second layer provided on the first layer and having a flat surface, and the second layer has a smaller plane shape than the first layer and is formed on a central part of the first layer at a distance from the perimeter of the first layer.

When this quartz crystal device is mounted on a wiring board by means of reflow soldering, such a configuration causes bubbles generated in melted solder in a region where the second layer is formed to be squeezed out into an outer region where only the first layer is formed due to a pressure of the self weight of the quartz crystal device acting on the melted solder. Bubbles grow as the temperature rises and are released into the atmosphere from the region where only the first layer is formed, and the melted solder is thus deaerated. After solidification of solder, voids caused by bubbles generated from flux thereby decrease and voids at positions corresponding to the central region of the outside terminal in particular reduce. With the reduction of voids, fewer cracks occur even when heat cycles are added. Here, the solder is not limited to a tin-lead alloy and also includes lead-free solder or the like.

### Brief Description of the Drawings:

FIGS. 1A and 1B are a cross-sectional view and a plan view, respectively, showing an example of configuration example of a conventional surface-mount crystal unit;
FIG. 1C is a plan view showing a crystal blank used in the crystal unit shown in FIGS. 1A and 1 B;
FIGS. 2A and 2B are a cross-sectional view and a plan view, respectively, showing another example of configuration example of a conventional surface-mount crystal unit;
FIG. 2C is a plan view of a crystal blank used in the crystal unit shown in FIGS. 2A and 2B;
FIG. 3 is a side view of the surface-mount crystal unit mounted on a wiring board;
FIGS. 4A and 4B are bottom views illustrating solder cracks caused by secular variations when the surface-mount crystal unit is mounted on a wiring board;
FIGS. 5A and 5B are a cross-sectional view and a bottom view of a surface-mount crystal unit, which is a quartz crystal device according to an exemplary embodiment of the present invention, respectively;
FIG. 6 is a bottom view showing another example of the surface-mount crystal unit based on the present invention; and
FIG. 7 is a bottom view showing a further example of the surface-mount crystal unit based on the present invention.

### Detailed Description of the Preferred Embodiments:

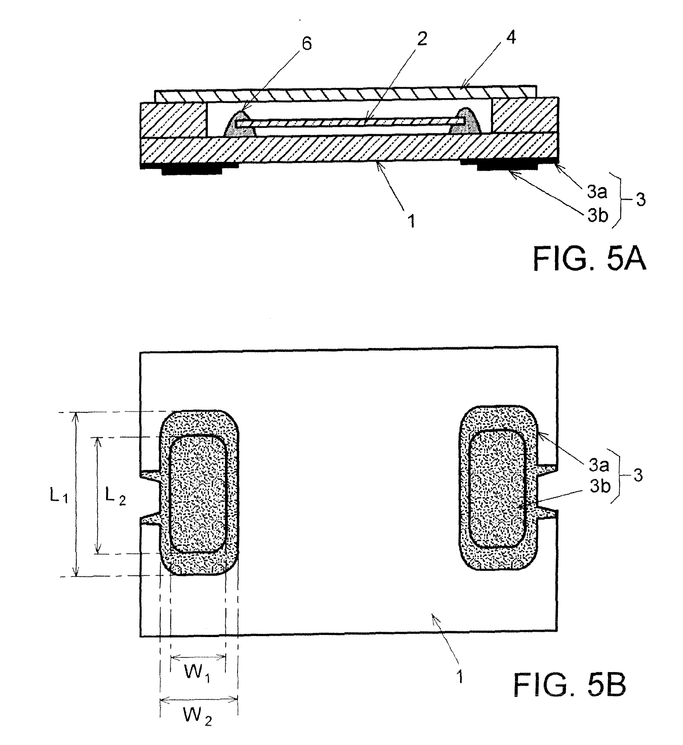

In FIGS. 5A and 5B which show a surface-mount crystal unit, which is a quartz crystal device for surface mounting according to an exemplary embodiment of the present invention, the same components as those shown in FIGS. 1A, 1B, 2A and 2B or the like are assigned the same reference numerals and explanations thereof will be simplified or omitted.

The surface-mount crystal unit shown in FIGS. 5A and 5B is a two-terminal type in the same way as that shown in FIGS. 1A and 1B, but is different from that shown in FIGS. 1A and 1B in the configuration of outside terminal 3 used when this crystal unit is surface-mounted on a wiring board. As described above, this crystal unit uses substantially rectangular parallelepiped container body 1 made of laminated ceramics, and crystal blank 2 similar to the one shown in FIG. 1C is hermetically encapsulated in a recess of container body 1. A pair of outside terminals 3 is provided at both ends of a substantially rectangular outer bottom surface in the longitudinal direction of container body 1. Outside terminals 3 are electrically connected to a pair of holding terminals provided in the recess of container body 1 via an end face electrode formed on an end face of container body 1 and a conductive path formed on the lamination plane between ceramic sheets making up container body 1 and thereby electrically connected to crystal blank 2.

As illustrated here, each outside terminal 3 has a two-layer structure with first layer 3a directly provided on the outer bottom surface of container body 1 and second layer 3b provided on first layer 3a. First layer 3a has a substantially rectangular plane shape, the surface of which is formed flat. Second layer 3b also has a substantially rectangular plane shape, the surface of which is formed flat, but has a smaller plane shape than first layer 3a. In the example shown here, each corner of first layer 3a is not right-angled but rounded and second layer 3b is provided concentrically with first layer 3a. The plane shape of second layer 3b is point-symmetric with respect to the center of the surface thereof. Such second layer 3b, especially the one shown here, is substantially mathematically similar to first layer 3a when considered with the exception of portions of connections with the end face electrodes of first layer 3a.

In this way, two layers 3a and 3b having different sizes are both provided, for example, as layers of tungsten (W) or molybdenum (Mo). More specifically, when ceramic green sheets or unburned raw ceramic sheets are stacked and burned to form container body 1, layers of tungsten or molybdenum corresponding to first and second layers 3a and 3b are provided on the ceramic green sheet by printing, then burned and thereby formed integral with container body 1. Nickel (Ni) and gold (Au) thin layers are formed on the exposed surfaces of first and second layers 3a and 3b using a technique such as electrolytic plating. After all, first layer 5a and second layer 5b having different sizes are formed of tungsten or molybdenum layers as underlying electrode layers in this outside terminal 3.

As illustrated here, the longitudinal direction of substantially rectangular outside terminal 3 is parallel to the short side of the outer bottom surface of container body 1. Assuming that the plane outside size of container body 1 is 3.2×2.5 mm, suppose length L1 of first layer 3a of outside terminal 3 is, for example, 2.3 mm, width W1 is, for example, 1.175 mm, length L2 of second layer 3b is, for example, 1.6 mm and width W2 is, for example, 0.831 mm. In this way, with respect to both length and width, suppose the ratio of values of first layer 3a and second layer 3b, that is, L2/L1 and W2/W1 are both set to approximately 0.7.

When such a surface-mount crystal unit is surface-mounted on a wiring board by means of reflow soldering, cream solder is applied to the wiring board beforehand by printing or the like, the crystal unit is then placed on the cream solder and the crystal unit together with the wiring board is put into a high temperature furnace. The cream solder is fine solder particles scattered in a flux component, a gas component including air in the flux expands in the initial stage of heating, a large quantity of bubbles are generated and the bubbles are also contained in the melted solder.

The melted solder is pressurized by the self weight of the crystal unit. In this case, the solder in the region of outside terminal 3 where second layer 3b is formed has a thinner layer than the solder in the region where only first layer 3a is formed and is subject to a greater pressure accordingly. As a result, bubbles contained in the melted solder in the region where second layer 3b is formed are expelled into the region where only first layer 3a is formed due to a pressure difference.

In this way, the bubbles expelled into the region where only first layer 3a is formed and bubbles originally existing in this layer grow as the temperature rises and are released into the atmosphere whose pressure is much lower than that of the region where only first layer 3a is formed, and as a result, the melted solder is deaerated. After that, the melted solder hardens as the temperature decreases and becomes a solder layer with fewer voids based on bubbles or the like.

In this way, even when large heat cycles are added after surface-mounted on the wiring board, the surface-mount crystal unit according to this exemplary embodiment has fewer voids in solder used for surface mounting, and can thereby prevent the occurrence of cracks in solder from corners on the perimeter side of the outside terminal where stress is concentrated most. Furthermore, even when cracks occur in the solder layer in the corners on the perimeter side of the outside terminal, there are fewer voids and it is possible to prevent cracks from growing inside the solder, and prevent the occurrence of cracks in the solder consequently.

In this crystal unit, second layer 3b of outside terminal 3 is smaller than first layer 3a but similar to and concentric with first layer 3a. This causes bubbles generated in melted solder in the region where second layer 3b is formed to uniformly move to all over the region where only first layer 3a is formed and to be released into the atmosphere. Furthermore, the ratio of the length and width of second layer 3b to the length and width of the first layer is set to 0.8 or less, or approximately 0.7 in the aforementioned example to thereby ensure that a difference in level is formed between the perimeter of first layer 3a and the perimeter of second layer 3b. The formation of such a difference in level ensures the release of bubbles generated in melted solder 8.

The crystal unit disclosed in JP-A-2001-308490 also has an outside terminal made up of a first layer and a second layer, but is different from the crystal unit of the present invention in that many small projections are provided by partially providing the second layer. In the art disclosed in JP-A-2001-308490, since many small projections are provided, bubbles remain in gaps between projections, which become voids after solidification. Further, since the perimeter of the first layer comes closer to the perimeter of the second layer, sufficient deaeration effects may be not obtained.

This exemplary embodiment adopts the shape of an arc retracted from right angles for the corners of each outside terminal 3 instead of right angles so that the corners are rounded. As a result, stress is reduced at the four corners of the outside terminal where stress caused by a difference in thermal expansion coefficient between the outside terminal and wiring board is concentrated most. Adopting such a shape for the outside terminal also reduces stress generated on the perimeter in the diagonal direction of the outer bottom surface of the container body based on the difference in thermal expansion coefficient between the ceramic making up the container body and wiring board. As described so far, the crystal unit of this exemplary embodiment can prevent the occurrence of cracks in the solder layer from the perimeter in the diagonal direction of the outer bottom surface of the container body.

The surface-mount quartz crystal device based on the present invention has been described taking the case of the two-terminal type crystal unit as an example, but the quartz crystal device to which the present invention is applicable is not limited to this.

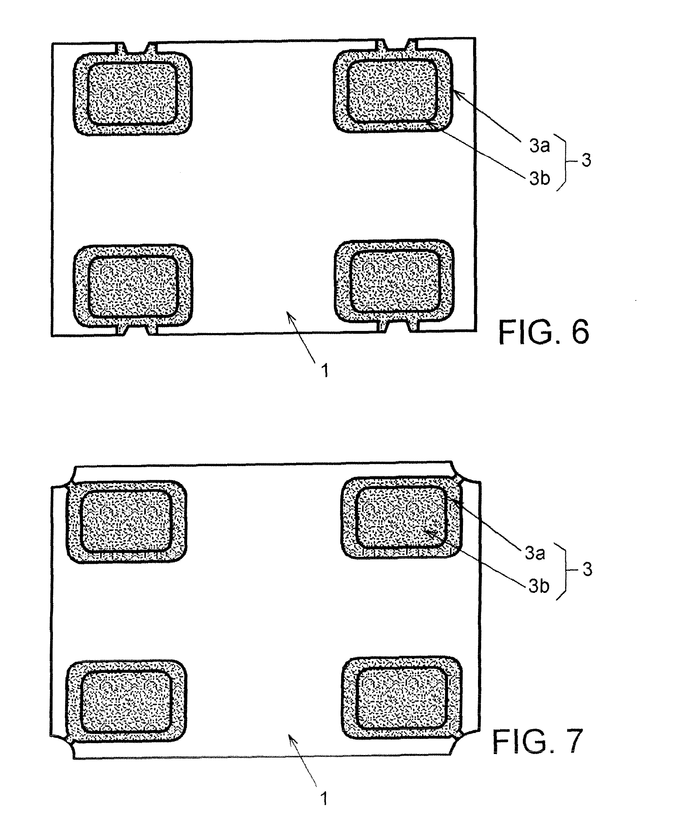

FIG. 6 shows a four-terminal type crystal unit to which the present invention is applied. This crystal unit is similar to that shown in FIGS. 2A and 2B, but is different from that shown in FIGS. 2A and 2B in that the outside terminal in the above described exemplary embodiment is used as outside terminal 3.

In the case of the four-terminal type crystal unit, the route used for electric connections between outside terminals 3 and the holding terminals can also be provided in the four corners of container body 1. That is, as shown in FIG. 7, the ridges of the four corners of container body 1 may be subjected to through-hole work and electrode layers may be formed on the through-hole worked surfaces as the end face electrodes.

Furthermore, the quartz crystal device to which the present invention is applied is not limited to the surface-mount crystal unit. For example, in a surface-mount crystal oscillator in which a crystal blank and an IC (integrated circuit) chip that integrates an oscillation circuit using the crystal blank are accommodated in the same container, the above described outside terminal can be used for the outside terminal used to surface-mount the crystal oscillator on a wiring board. In the case of the crystal oscillator, since four outside terminals including a power terminal, grounding terminal and output terminal are normally provided, the arrangement of the outside terminals is as shown in FIG. 6 or FIG. 7.

Moreover, the plane shape of the outside terminals according to the present invention is not limited to a rectangular shape or rectangular shape with rounded corners. First layer 3a may have a rectangular shape, while second layer 3b may be an elliptic or circular shape. Furthermore, both the first layer and second layer may be elliptic or circular shapes. When both the first layer and second layer are circle shaped and arranged concentrically with each other, since the distance from the center to the perimeter of the first layer and the distance to the perimeter of the second layer are uniform, bubbles are released more uniformly.

## Claims

1. A quartz crystal device comprising:
a container;
a crystal blank hermetically encapsulated in the container; and
at least two outside terminals provided on an outer bottom surface of the container and used for surface mounting,
wherein the each outside terminal has a two-layer structure with a first layer provided on the outer bottom surface and a second layer provided on the first layer and having a flat surface, and
the second layer has a smaller plane shape than the first layer and is formed on a central part of the first layer at a distance from the perimeter of the first layer.

2. The quartz crystal device according to claim 1, wherein the first layer and the second layer are provided concentrically with each other.

3. The quartz crystal device according to claim 2, wherein the second layer has a plane shape which is point-symmetric with respect to a center of a the surface of the second layer.

4. The quartz crystal device according to claim 2, wherein the first layer has a substantially rectangular plane shape and the second layer is provided to be similar to the first layer.

5. The quartz crystal device according to claim 4, wherein the first layer has a rectangular shape with rounded corners.

6. The quartz crystal device according to claim 4, wherein a ratio of length and width of the second layer to length and width of the first layer is 0.8 or less.

7. The quartz crystal device according to claim 5, wherein a ratio of length and width of the second layer to length and width of the first layer is 0.8 or less.

8. The quartz crystal device according to claim 1, wherein the outer bottom surface has a substantially rectangular plane shape.

9. The quartz crystal device according to claim 8, wherein the outside terminals are provided at both ends in a longitudinal direction of the outer bottom surface of the container body.

10. The quartz crystal device according to claim 8, wherein the outside terminals are provided in four corners of the outer bottom surface of the container.
